(19) Europäisches Patentamt / European Patent Office / Office européen des brevets

(11) **EP 4 782 855 A1**

(12) **EUROPEAN PATENT APPLICATION**

(43) Date of publication:
29.07.2026 Bulletin 2026/31

(21) Application number: 25153345.1

(22) Date of filing: 22.01.2025

(51) International Patent Classification (IPC):
**G01R 31/396** (2019.01)     **G01R 31/367** (2019.01)
**G01R 31/392** (2019.01)

(52) Cooperative Patent Classification (CPC):
**G01R 31/392; G01R 31/367; G01R 31/396**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Technische Hochschule Ingolstadt, in Vertretung**
**des Freistaates Bayern**
**85049 Ingolstadt (DE)**

(72) Inventors:
• **LEWERENZ, Meinert**
**85049 Ingolstadt (DE)**

• **AZZAM, Mohamed**
**81379 München (DE)**
• **SCHWERTNER, Stefan**
**85049 Ingolstadt (DE)**
• **ENDISCH, Christian**
**85290 Geisenfeld (DE)**

(74) Representative: **Maiwald GmbH**
**Elisenhof**
**Elisenstraße 3**
**80335 München (DE)**

Remarks:
Amended claims in accordance with Rule 137(2) EPC.

(54) **COMPUTER-IMPLEMENTED METHOD FOR DETERMINING CALENDAR AGING CHARACTERISTICS OF BATTERY CELLS**

(57) The disclosure relates to a computer-implemented method (100) for determining an anode calendar aging characteristic and a cathode calendar aging characteristic of one or more battery cells (1) of the same battery cell type, the method (100) comprising:
- obtaining check-up measurement data from check-up measurements of the one or more battery cells (1), the check-up measurement data being indicative of a capacity loss rate ($I_{C\_loss}$) of the one or more battery cells (1);
- obtaining float current measurement data from a float current measurement of the one or more battery cells (1), the float current measurement data being indicative of a float current ($I_{float}$) of the one or more battery cells (1);
- obtaining open circuit voltage, OCV, measurement data from an OCV measurement of one of the one or more battery cells (1), the OCV measurement data being indicative of an OCV of the one or more battery cells (1);
- providing the check-up measurement data, the float current measurement data, and the OCV measurement data as input to a calendar aging model; and
- determining, using the calendar aging model, the anode calendar aging characteristic and the cathode calendar aging characteristic, the anode calendar aging characteristic being indicative of calendar aging due to solid electrolyte interface, SEI, growth at an anode of the one or more battery cells (1), and the cathode calendar aging characteristic being indicative of calendar aging due to lithiation of a cathode of the one or more battery cells (1).

100

| 101 | → | 102 | → | 103 | → | 104 | → | 105 |

Fig. 1

**(Cont. next page)**

EP 4 782 855 A1

Fig. 2

**Description**

**TECHNICAL FIELD**

The present invention generally relates to the field of battery technology and determining calendar aging characteristics of battery cells. Specifically, the present invention relates to a computer-implemented method for determining an anode calendar aging characteristic and a cathode calendar aging characteristic of one or more battery cells of the same battery cell type. Further, the present invention specifically relates to a computer program product, a data processing system and a battery cell measurement system associated with the computer-implemented method.

**BACKGROUND**

Battery technology development and optimization have gained significant importance in recent years, particularly (but not only) in the context of electric mobility and renewable energy. A crucial aspect of battery cell utilization is understanding their aging behavior, which is vital for various applications and industries.

There are many different battery cell types available, each characterized by specific chemistry and design. Every battery cell type exhibits unique calendar aging behavior, complicating the development of uniform solutions for life cycle optimization and prediction.

In this regard, one issue lies in the information gap between manufacturers of the battery cells and users or, in other words customers of the manufacturers, employing the manufactured battery cells in various systems and devices, such as automobiles, electronic user devices, energy storage systems, and others. Battery cell manufacturers often lack or at least do not share detailed knowledge about the various applications in downstream industries, meaning that even when such knowledge exists, it is frequently not shared with the users employing the battery cells in the various devices and systems. This leads to a substantial information gap that impairs the effective use and management of battery cells of the users.

Understanding the aging processes and lifespan of battery cells of different battery cell types and from different manufacturers is therefore crucial for the users. This knowledge is critical for several issues of battery technology. It enables the optimization of cell formation processes and the selection of suitable cell chemistry. Accurate predictions of battery cell lifespan are essential for planning and managing battery-powered devices and systems. In this regard, calendar aging is one particularly relevant aging factor over the lifespan of battery cells as it is independent from whether the battery cells are actively used or not.

The development of precise models and the parameterization of algorithms for battery-friendly operation require detailed knowledge of the aging behavior. Advanced algorithms for predictive maintenance are based on a profound understanding of battery cell aging. For the reuse of battery cells in second-life applications and the certification and utilization of battery cells with unknown aging characteristics before further processing, knowledge of their aging state is indispensable.

Overcoming these challenges and bridging the knowledge gap between manufacturers and users of battery cells represent important research and development goals. Comprehensive understanding of calendar battery cell aging is crucial for optimizing the applications of devices and systems employing battery cells.

**SUMMARY OF THE INVENTION**

The above problem is at least partially solved or alleviated by the subject matters of the independent claims of the present disclosure, wherein further examples are incorporated in the dependent claims.

According to an aspect of the present disclosure, there is provided a computer-implemented method for determining an anode calendar aging characteristic and a cathode calendar aging characteristic of one or more battery cells (in particular of the same battery cell type). The method comprises obtaining check-up measurement data from one or more (in particular from two or more or generally from) check-up measurements of the one or more battery cells, the check-up measurement data being indicative of a capacity and/or capacity loss rate ($I_{C\_loss}$) of the one or more battery cells. Further, the method comprises obtaining float current measurement data from a float current measurement of the one or more battery cells, the float current measurement data being indicative of a float current ($I_{float}$) of the one or more battery cells. Further, the method comprises obtaining open circuit voltage, OCV, measurement data from an OCV measurement of one of the one or more battery cells, the OCV measurement data being indicative of an OCV of the one or more battery cells. Moreover, the method comprises providing the check-up measurement data, the float current measurement data, and the OCV measurement data as input to a calendar aging model. Further, the method comprises determining, using the calendar aging model, the anode calendar aging characteristic, and the cathode calendar aging characteristic. The anode calendar aging characteristic is indicative of calendar aging due to solid electrolyte interface, SEI, growth at an anode of the one or more battery cells. The cathode calendar aging characteristic is indicative of calendar aging due to lithiation of a cathode of the one or more battery cells.

The method of the first aspect being computer-implemented means that it is an at least partially or fully computer implemented method. This means that at least one, multiple or all the steps of the method may be carried out by a data processing system, which may comprise one or more computers or, in other words, computing units. That data processing system may further comprise a storage for storing a computer program as a product, the instructions of which when executed by the one or more computers causes at least partially or fully that the computer-implemented method is being carried out. The data processing system may be part of a battery cell measurement system as further described herein. Different steps may be carried out by the same or by different computers in case the data processing system comprises several computers. A computer is herein understood as a data processing apparatus, which can carry out some, multiple or all steps as defined by the method by processing corresponding computer-executable instructions, which may be written in a computer-readable code or, in other words, as instructions and can be stored as part of a computer program.

The computer-implemented method as described herein is not limited towards a full computer-implementation. Instead, several of the steps of the method may alternatively or additionally be carried out as non-computer-implemented steps, specifically but not limited thereto as physical measurement steps, which may be carried out by one or more measurement devices or units, such as but not limited to current measurement devices, voltage measurement devices, and similar. For example, the method of the first aspect may alternatively or additionally comprise carrying out the check-up measurements of the one or more battery cells. Thereby, the check-up measurement data may be obtained. For example, measurement data may generally be obtained by a respective measurement device and provided or forwarded to the data processing system or computer, where it may be obtained as measurement data and further processed in a computer-implemented process as described herein. Similarly, the float current measurement of the one or more battery cells and/or the OCV measurement of the one or more battery cells may be carried out alternatively or additionally in the method of the first aspect, the measurement data gathered thereby being provided to the data processing system for being obtained and further processed there.

Alternatively, the method of the first aspect may be fully computer-implemented or, in other words, carried out on a computer or data processing level, where the obtained different measurement data are processed as input of the calendar aging model to determine the respective aging characteristics of the anode and the cathode.

In the context of battery testing and characterization, various measurements can be employed to assess battery performance and health. The check-up measurements referred to herein and used according to the method of the first aspect may encompass one or more different test types from a broad range of different tests designed to evaluate a battery's overall health and performance.

Specifically, the check-up measurements may in particular include or be in the form of capacity tests but are not limited thereto. Capacity testing involves fully charging and then discharging the battery cell under controlled conditions to determine its actual energy storage capability. Specifically, that charging, and discharging may be done at a low current, e.g. at approximately 0.1 C. For example, internal resistance measurements and self-discharge rate assessments could also be employed as part of the check-up measurements. Internal resistance measurements help identify potential issues such as corrosion or mechanical defects that may affect the battery cell's performance. Self-discharge rate evaluations assess how quickly the battery loses charge when not in use, which can indicate degradation or other problems. Generally, through the check-up measurements, it is possible to obtain capacity values for the one or more battery cells. The difference or, in other words, delta between the capacity values from consecutive check-up measurements is the capacity loss rate, which may be accordingly determined. Accordingly, the capacity loss rate represents or can be seen graphically as the gradient of the slope or curve between the capacities of consecutive check-up measurements.

Open Circuit Voltage, OCV, refers to the potential difference between a battery cell's positive and negative terminals when no external current is flowing. This measurement provides insights into the battery cell's state of charge and can be used to estimate its overall condition. OCV is typically measured after allowing the battery to rest for a period of time to reach equilibrium. For this purpose, the OCV measurement may for example be carried out on a battery cell after the float current measurement. For the OCV measurement within the herein disclosed method, it may be sufficient to measure only a single battery cell, in case the method is carried out to determine the aging characteristics for several battery cells from the same battery cell type. For example, the OCV measurement may be based on or use galvanostatic intermittent titration technique, GITT. GITT may include applying a series of current pulses, each of which may be followed by a relaxation period. Thereby, the technique provides information on open-circuit voltage changes and internal resistance.

Float current measurement, which is sometimes also referred to as float voltage measurement, on the other hand, is the current or voltage at which a fully charged battery is maintained to compensate for self-discharge and keep it at full SOC or at a desired SOC level. In particular, float current measurement means maintaining the battery cell at a specific voltage and measuring the current required to do that, particularly for a desired SOC level. This current or voltage is applied continuously or during specific charging phases and varies depending on the battery chemistry and construction.

In the present method, these various measurement techniques are combined using a calendar aging model, which receives the different measurement data from the various measurements as input, to provide a comprehensive understanding of the calendar aging characteristic of the one or more battery cells.

The different measurement data, the calendar aging model, the calendar aging characteristics and the battery cell type are herein to be understood broadly.

The different measurement data may, for example, directly comprise the respective measurement parameter such as capacity loss rate, float current or OCV or may comprise one or more measurement values, which may be used, using data processing and mathematical equations or models, to determine the respective measurement parameter from these measurement values. In other words, the obtained measurement data does not necessary need to be obtained as the respective measurement parameter, but it may be sufficient to receive measurement data that is processed first before determining the measurement parameter described in the method, i.e. capacity loss rate, float current and/or OCV. Also, the different measurement data may comprise any of distinct values, time-series data, relationships of different measurement values with respect to each other, combinations of the herein mentioned, and similar. Generally, the different measurement data may be in the form of tables, functions, plotted data, combinations of the herein mentioned, and similar.

The calendar aging model may for example be defined as an algorithm, a mathematical representation or generally any computer model configured to determine the different calendar aging characteristics described herein. The calendar aging model is enabled to do so by the input provided in terms of the specific measurements described herein, one of which is the float current measurement providing the float current, the other one is the capacity loss rate as determined by the check-up measurements and yet another one is the OCV measurement and the therefrom derived OCV.

The calendar aging model may be configured to predict and/or quantify the degradation of battery cell performance over time when the battery cell is not in active use, i.e. neither actively charged nor discharged, for which the different calendar aging characteristics are determined. Specifically, calendar aging of battery cells refers to the gradual degradation of battery cell performance that occurs over time, even when the battery is not in active use. This aging process takes place regardless of whether the battery is being charged or discharged.

The calendar aging characteristics may, similar to the measurement data, generally be in any form such as not limited distinct values, time-series data, functions, approximations, tables, plotted data, parameters depending on time or other values, any combination of the aforementioned, and similar. It is important that there are two different calendar aging characteristics, one representing the calendar aging at the anode and the other one representing the calendar aging at the cathode.

All battery cells may be lithium-ion battery cells. The same battery cell type may refer to battery cells with at least partially or fully identical characteristics, specifically but not only in terms of their format, chemistry, and/or construction. For example, lithium-ion battery cells may use different active cell materials. Also, the same battery cell type may include characteristics that may not be per se visible, qualifiable and/or quantifiable, such as the battery cell's manufacturer, model and/or manufacturer specifications.

A specificity of the method and the calendar aging model is that it enables, using the different measurement data, to not merely determine a single characteristic describing the overall calendar aging of the one or more battery cells, but determine two distinctive calendar aging characteristics, one for the anode and one for the cathode, where each one attributes for the respective reason or cause for the calendar aging, namely SEI growth at the anode and cathode lithiation at the cathode.

The result or, in other words, output of the method thereby significantly enhances the knowledge about the battery cells and can be advantageously used for the above described several issues of battery technology. For example, by being able to test different battery cells for calendar aging and attributing it to either the anode or cathode, the use in devices and systems or generally the applications may be optimized, e.g. to reduce the different effects of SEI growth and cathode lithiation in a targeted way. Of course, there are also other advantageous ways of using the unique identification of the anode calendar aging characteristic and cathode calendar aging characteristic determined by the method, e.g., within research, for battery cell design optimization and manufacturing, and so on.

The method may further comprise outputting, storing and/or providing the determined anode calendar aging characteristic and the cathode calendar aging characteristic, e.g. on a display, on a storage device, to another computer, via wireless transmission, a cloud and/or wired transmission, or by any other means. Correspondingly, the characteristics may be displayed to a user, be stored for later usage and/or forwarded for further usage, e.g. on another computer. Such further usage may for example include designing of applications including devices and systems with the respective battery cells.

In an example, the check-up measurement data may be from check-up measurements of several battery cells (in particular two, four, six, eight or more battery cells) of the same battery cell type. In other words, several check-up measurements may be performed on a number of battery cells. Specifically, the check-up measurements may be separately performed for each one of the several battery cells. For example, two check-up measurements may be separately performed on each one of eight battery cells. Also, the float current measurement data may be from a float current measurement of the several battery cells. Due to the typically long duration of the measurements, specifically the float current measurements, the measurements, at least the float current measurements but optionally also the check-up measurements on each one of the several battery cells may be carried out at least partially or fully simultaneously in time.

Ultimately, the anode calendar aging characteristic and the cathode calendar aging characteristic can be more reliably determined for several battery cells of the same battery cell type, the composition or generally characteristics of which may not be known to a user of the battery cells.

In an example, each one of the several battery cells may have a different state of charge, SOC. Accordingly, the method is not only determined on several battery cells of the same battery cell type, but also on different SOC levels, thereby covering a broad range of SOC levels and the influences this can have on the calendar aging characteristics. For the respective float current measurements, a different SOC level may be maintained for each battery cell. The time required for the measurements compared to measuring battery cells over their full SOC range can thereby be reduced. Hence, the method may more accurately and faster determine the anode and cathode calendar aging characteristics.

In an example, the anode calendar aging characteristic may be indicative of an SEI growth current ($I_{SEI\_growth}$). The cathode calendar aging characteristic may be indicative of a cathode lithiation current ($I_{Cathode\_Lithiation}$). SEI growth current refers to the small but continuous current associated with the ongoing formation and growth of the SEI layer on the anode surface. Cathode lithiation current is the current flow associated with the insertion of e.g. lithium ions into the cathode material during the charging process. These currents may be determined as at least approximate characterizations for the respective calendar aging effects of SEI growth and cathode lithiation.

In an example, the determining of the SEI growth current ($I_{SEI\_growth}$) and the cathode lithiation current ($I_{Cathode\_Lithiation}$) may comprise:

- determining, based on the OCV measurement data, an anode scaling factor ($SF_{Anode}$) for the SEI growth current ($I_{SEI\_growth}$) and a cathode scaling factor ($SF_{Cathode}$) for the cathode lithiation current ($I_{Cathode\_Lithiation}$); and
- determining the SEI growth current ($I_{SEI\_growth}$) and the cathode lithiation current ($I_{Cathode\_Lithiation}$) based on the anode scaling factor ($SF_{Anode}$), the cathode scaling factor ($SF_{Cathode}$) and the float current ($I_{float}$).

The scaling factors may be understood as the ratio of the slope of the anode or cathode to the full battery cell. The scaling factors thereby describe how the individual electrode behaviors of anode and cathode relate to the overall performance of the complete battery cell in terms of calendar aging effects. The scaling factors vary between battery cells of different battery cell types.

In an example, the determining of the anode scaling factor ($SF_{Anode}$) and the cathode scaling factor ($SF_{Cathode}$) may comprise:

- determining a differential voltage capacity ($k_{full\ battery\ cell}$) of the one or more battery cells using differential voltage analysis, DVA, of the OCV;
- estimating an anode differential voltage capacity ($k_{Anode}$) of the anode and a cathode differential voltage capacity ($k_{Cathode}$) of the cathode as parts of the full differential voltage capacity ($k_{full\ battery\ cell}$); and
- determining the anode scaling factor ($SF_{Anode}$) and the cathode scaling factor ($SF_{Cathode}$) based on the anode differential voltage capacity ($k_{Anode}$) and the cathode differential voltage capacity ($k_{Cathode}$).

DVA is a technique generally used to characterize battery cell performance and degradation by examining the relationship between voltage and capacity during charge or discharge cycles. It involves calculating the derivative of voltage with respect to capacity (dV/dQ) or the inverse (dQ/dV). To determine the anode and cathode parts of the differential voltage capacity for the full battery cells, an estimation may be used, and based on the differential voltage capacities of anode and cathode, which represent the slopes of the anode and cathode, the scaling factors of anode and cathode may be determined given the ratio definition of the scaling factors.

In an example, the anode differential voltage capacity ($k_{Anode}$) and/or the cathode differential voltage capacity ($k_{Cathode}$) may be estimated based on a battery cell type of the one or more battery cells. For example, an empirical estimation may be carried out. For such estimation, the distribution of $k_{Anode}$ and $k_{Cathode}$ for the given battery cell type, in particular the active cell material, may be known, e.g. empirically. Specifically, for different battery cell types, in particular one or more different battery cell characteristics such as (but not limited) to the active cell material, different distributions may be known based on experiment, mathematical models or estimations, literature, any combination of the herein mentioned, and similar. For this known battery cell characteristic(s), the expected or known distribution can now be used to approximate the differential voltage capacities of anode and cathode $k_{Anode}$ and $k_{Cathode}$ based on the determined differential voltage capacity $k_{full\ battery\ cell}$ of the full battery cell.

In an example, the calendar aging model may be based on the mathematical relationship of

$$SF_{Anode} = \frac{|k_{Anode}|}{|k_{full\ battery\ cell}|} \text{ (Eq. 1)},$$

$$SF_{Cathode} = \frac{|\, k_{Cathode}\,|}{|\, k_{full\ battery\ cell}\,|} \text{ (Eq. 2)},$$

$$I_{float} = SF_{Anode} \cdot I_{SEI\_growth} + SF_{Cathode} \cdot I_{Cathode\_Lithiation} \text{ (Eq. 3)},$$

and

$$I_{C\_loss} = I_{SEI\_growth} - I_{Cathode\_Lithiation} \text{ (Eq. 4)}$$

for determining the SEI growth current ($I_{SEI\_growth}$) and the cathode lithiation current ($I_{Cathode\_Lithiation}$). These mathematical relationships may be part of the calendar aging model, on which the calendar aging model may be built. However, it is noted that the mathematical equations and operations given herein together with the different steps of determinations, e.g. using DVA, estimation, and similar, are merely one way described in detail herein to determine the different calendar aging characteristics for anode and cathode. The method of the first aspect is not limited to these particular equations, operations or generally the thereby described calendar aging model. Specifically, other analysis methods, assumptions, estimations and similar may be envisioned to carry out the method.

In an example, a change in the anode scaling factor ($SF_{Anode}$) and the cathode scaling factor ($SF_{Cathode}$) over time may be determined. Thereby, the aging of the battery cells may be taken into account over time in view of the change of the scaling factors.

In an example, the float current measurement data may be indicative of the float current ($I_{float}$) of the one or more battery cells during a steady state assumed after a settling time, after which anode overhang of the one or more battery cells has substantially settled. Specifically, in a settling phase until the settling time has been reached, polarization effects and effects due to concentration differences may be balanced out. These effects also include the anode overhang effect, which leads to apparent aging that subsides after a certain time. According to measurements, this occurs without additional optimization after approximately 60-90 days. After these processes subside, the float current signal approaches a stable state or, in other words, steady state. This value is typically in the µA range, scales with the battery capacity, and correlates with irreversible calendar aging, which may thereby be determined.

In an example, a first check-up measurement of the check-up measurements may be carried out before the float current measurement. A second check-up measurement of the check-up measurements may be carried out after the float current measurement. The first check-up measurement may for example be an initial check-up measurement. The first check-up measurement may be performed to determine functionality of the one or more battery cells for consequent measurement or, in other words, testing. Such a first initial and, optionally, another first or consequent first check-up measurement may be performed before the float current measurement. Alternatively, the other first check-up measurement after the first initial check-up measurement or, additionally, the herein mentioned second check-up measurement may be performed after the float current measurement. The float current may be determined based on the measurement data from two of any of the initial first, other first and second check-up measurements. Note that the denomination of first and second check-up measurement are herein meant to distinguish the check-up measurements as defined herein from one another and not to give a limiting order of measurements. Specifically, the first check-up measurement may be multiple check-up measurements before the float current measurement, whereas the second check-up measurement may be multiple check-up measurements after the float current measurement.

In an example, at least the float current measurement data may be from a float current measurement, in which the one or more battery cells are kept at a substantially constant temperature, the temperature in particular being within the range of 20 to 40 °C. In particular, the temperature range may for example be within the range of 25 to 35 °C. For example, the one or more battery cells may be kept at a temperature of around 30°C. Substantially generally refers herein to approximately and can include deviations due to technical reasons. Keeping the temperature of the battery cell(s) substantially constant allows for verifiable results. The advantage of the suggested temperature range is that up to approx. 50 °C, no additional aging effects on the battery cells will be typically triggered. Additionally, the battery cells can more quickly achieve the stead state described above. Additionally, the check-up measurements and/or the OCV measurement may be performed at the same substantially constant temperature as during the float current measurement or at least within the specified temperature range.

In an example, at least the float current measurement data may be from a float current measurement, in which a temperature of the one or more battery cells is gradually increased or decreased. Additionally, the check-up measurements may be performed at the same gradually increasing or decreasing temperatures of the battery cell(s). For the gradually increasing temperature, the float current may be measured in a steady state while gradually increasing the temperature. The battery cell is particularly stable in the long term if the float current has not increased at the reference temperature after being subjected to a temperature profile. If, however, it does not remain stable, the previous temperature profile influences aging and a path dependency exists, which is of particular importance for modeling and thus for lifetime prediction. Similarly, gradually decreasing the temperature may be of importance for modeling and lifetime prediction.

According to a second aspect of this disclosure, there is provided a computer program product comprising instructions which, when the program is executed by a data processing system, cause the data processing system to carry out the method according to the first aspect of this disclosure.

The computer program product may be a computer program as such, meaning a computer program consisting of or comprising a program code to be executed by the data processing system or, in other words, one or more computers thereof. Alternatively, the computer program product may be a product such as a data storage, in particular a computer-readable data storage medium, on which the computer program may be temporarily or permanently stored.

According to a third aspect of this disclosure, there is provided a data processing system configured to carry out the method according to the first aspect of this disclosure.

The data processing system may comprise one or more computers as previously described and, optionally, the computer program product of the second aspect of this disclosure.

According to a fourth aspect of this disclosure, there is provided a system for a battery cell measurement system, the battery cell measurement system comprising the data processing system of the fourth aspect of this disclosure, a constant voltage source, a current measurement device, one or more voltage measurement devices, and a temperature control device for controlling the temperature of the one or more battery cells.

The battery cell measurement system at least allows for the float current measurement described herein. The same measurement system, with or without modifications, or alternative measurement systems or setups may be provided for the other measurements, specifically check-up measurements and OCV measurements, as described herein.

It is noted that the above aspects, examples and features may be combined with each other irrespective of the aspect involved.

The above and other aspects of the present disclosure will become apparent from and elucidated with reference to the examples described hereinafter.

## BRIEF DESCRIPTION OF THE DRAWINGS

Exemplary embodiments will be further described with reference to Figures, wherein:

Figure 1 shows a schematic illustration of a computer-implemented method for determining an anode calendar aging characteristic and a cathode calendar aging characteristic of battery cells of the same battery cell type;

Figure 2 shows a schematic illustration of a battery cell measurement system comprising a data processing system for carrying out the method shown in Fig. 1;

Figure 3 shows a graphical illustration showing check-up measurements and float current measurements for the method of Fig. 1;

Figure 4 shows a schematic illustration of the theoretical change of state of the battery cell during floating, when SEI growth on the anode surface occurs;

Figure 5 shows a schematic illustration of the theoretical change of state of the battery cell during floating, when lithiation occurs on the cathode;

Figure 6 shows graphical illustrations of different measurements for obtaining different measurement data to be used within the method of Fig. 1;

Figure 7 shows plotted calendar aging characteristics as determined by the method of Fig. 1 using the measurement data of Fig. 6;

Figure 8 shows a schematic illustration of a calendar aging model used in the method of Fig. 1, which receives the measurement data of Fig. 6 as input and provides the plotted calendar aging characteristics of Fig. 7 as output; and

Figure 9 shows graphical illustrations of scaling factors in dependency of cell voltage as determined by the calendar aging model of Fig. 8, including the change of the scaling factors over time for an aged battery cell.

The Figures are schematic only and not true to scale. In principle, identical or like parts, elements and/or steps are provided with identical or like reference numerals in the Figures.

## DETAILED DESCRIPTION OF THE INVENTION

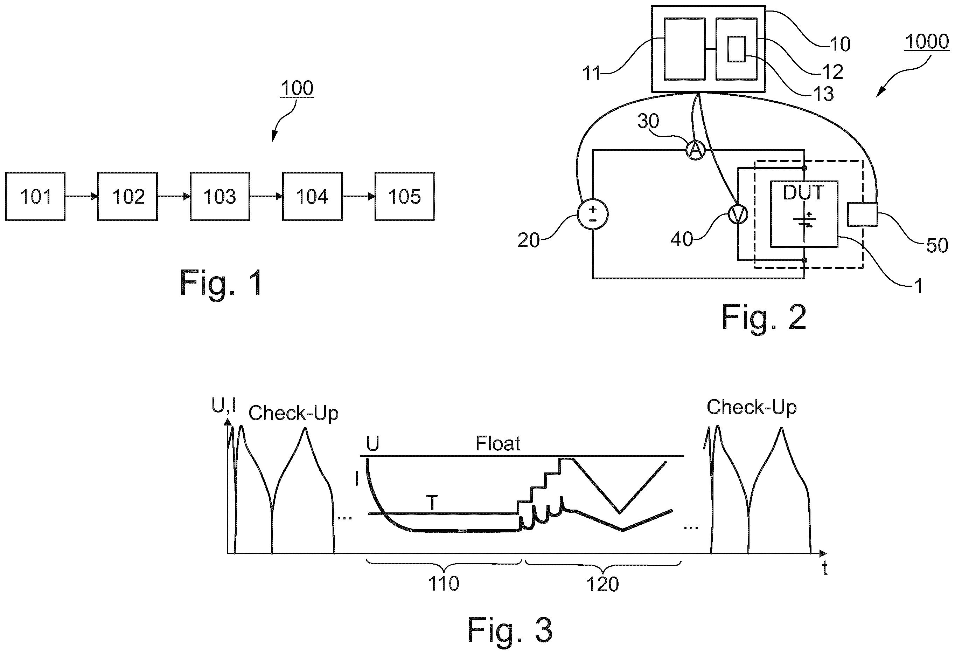

Figure 1 shows a schematic illustration of a computer-implemented method 100 for determining an anode calendar aging characteristic indicative of or in the form of an SEI growth current $I_{SEI\_growth}$ of several battery cells 1 of the same battery cell type under test. The method 100 also determines a cathode calendar aging characteristic indicative of or in the form of a cathode lithiation current $I_{Cathode\_Lithiation}$ (also denoted as $I_{CL}$ in the Figures) for these battery cells 1.

Figure 2 shows a schematic illustration of a battery cell measurement system 1000 comprising a data processing system 10 for carrying out the computer-implemented method 100 shown in Fig. 1. In the exemplary illustration of Fig. 2, a battery cell measurement system 1000 for a single battery cell 1, referred to as device under test, DUT, is shown. However, there may be multiple electrical measurement circuits as shown for the battery cell 1 in Fig. 2, each one of the electrical measurement circuits comprising one or more of the illustrated constant voltage source 20, current measurement device 30, voltage measurement device 40, and temperature control device 50. Each one of these electrical measurement circuits may measure one of the several battery cells 1 of the same battery cell type. Each one of these electrical measurement circuits may be connected to the data processing system 10.

In this exemplary configuration, the data processing system 10 is a single computer having a processor 11, a computer program product 12 in the form of a computer-readable medium, storing thereon a computer program 13 with instructions to be executed by the processor 11 for carrying out the computer-implemented method 100 of Fig. 1.

In a step 101 of method 100, as schematically illustrated in Fig. 1, the data processing system 10 obtains check-up measurement data from check-up measurements of the battery cells 1. The check-up measurement data is indicative of a capacity loss rate $I_{C\_loss}$ of the battery cells 1. Specifically, Figure 3 shows a graphical illustration showing check-up measurements and float current measurements for the method 100 of Fig. 1. In this case, any one of the exemplary illustrated first initial and/or first other check-up measurements on the left side of Fig. 3 and any one of the exemplary illustrated second consequent check-up measurements on the right side of Fig. 3, with a float current measurement on by the battery cell measurement system 1000 in between, may be used to determine the capacity loss rate $I_{C\_loss}$ of each one of the battery cells 1. The check-up measurement data may accordingly be provided to the data processing system 10, where it is obtained for further processing as described herein.

In a step 102 of method 100, which may precede, follow or be carried out in parallel to step 102 of method 100, the data processing system 10 obtains float current measurement data from a float current measurement of the battery cells, the float current measurement data being indicative of a float current $I_{float}$ of each one of the battery cells 1, in particular during a steady state assumed after a settling time, after which anode overhang of the battery cells 1 has substantially settled as can be seen within the first section 110 of float current measurement in Fig. 3. The second section 120 of the float current measurement shown in Fig. 3 may optionally be used for fast aging tests but is not necessary here.

In a step 103 of method 100, which may precede, follow, or be carried out in parallel to step 102 and/or step 103 of method 100, the data processing system 10 obtains open circuit voltage, OCV, measurement data from an OCV measurement of one of the battery cells 1, the OCV measurement data being indicative of an OCV of the battery cells 1. Then, the data processing system 10 may further process that OCV of the battery cells 1, specifically by means of differential voltage analysis, DVA, and generally as further explained herein.

In any case, in a step 104 of method 100 following steps 101, 102, 103, the different measurement data obtained in steps 101, 102, 103 is provided to a calendar aging model as input. The calendar aging model may be provided on or as part of the computer program product 12 and executed by the processor 11.

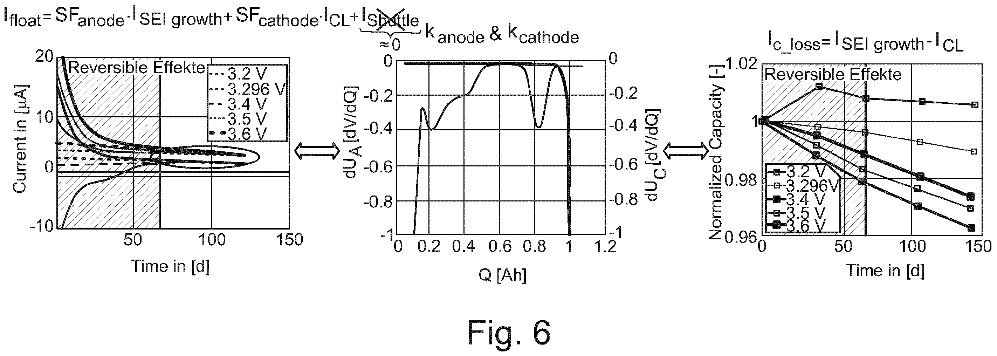

The different measurement data is exemplary shown for an exemplary test of five battery cells 1 in the form of graphical illustrations in Figure 6. Specifically, these battery cells 1 may be provided at different state of charge, SOC, levels. Any number of battery cells 1, e.g., 2 to 8 or more can be measured for the method 100.

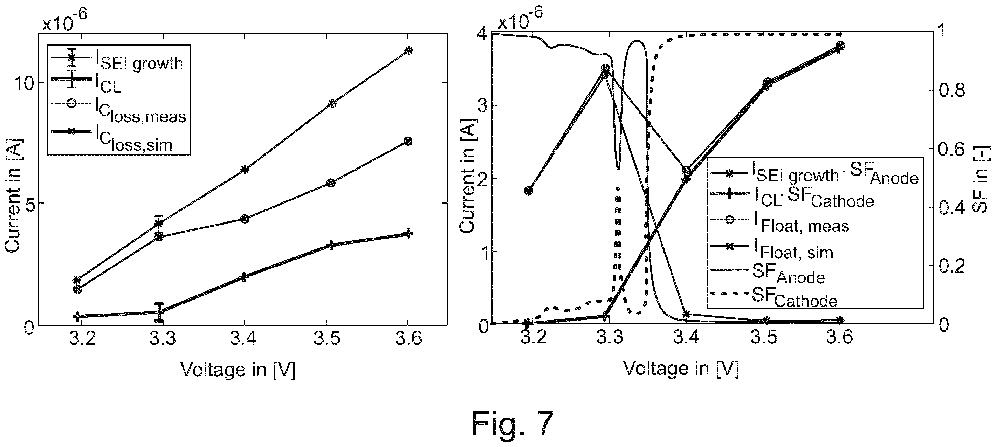

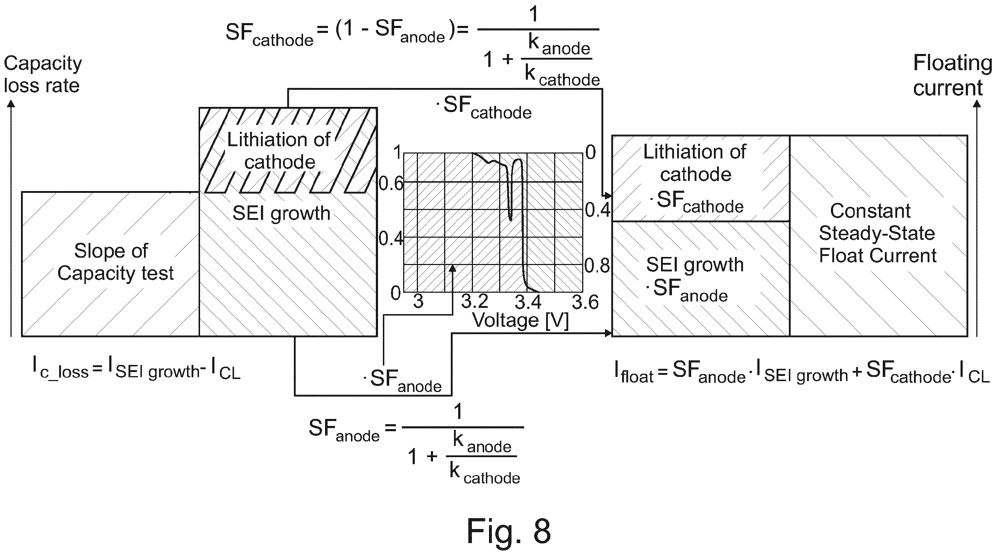

Further, a schematic illustration of an example of the calendar aging model usable in the method 100 is shown in Figure 8. The calendar aging model receives the measurement data schematically depicted in Fig. 6 as input and provides the plotted calendar aging characteristics shown schematically and exemplary in Figure 7 as output.

Specifically, the method 100 in step 105 following step 104 comprises determining, using the calendar aging model, the anode calendar aging characteristic, and the cathode calendar aging characteristic. The calendar aging characteristic is indicative of calendar aging due to solid electrolyte interface, SEI, growth at an anode of the battery cells 1 of the same battery cell type, and the cathode calendar aging characteristic is indicative of calendar aging due to lithiation of a cathode of the battery cells 1 of the same battery cell type.

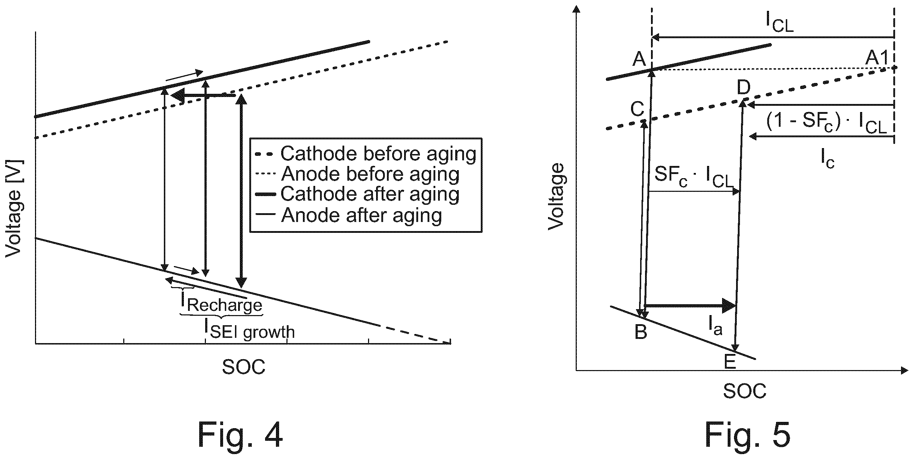

Figure 4 shows a schematic illustration of the theoretical change of state of the battery cells 1 during the floating measurement illustrated in Fig. 3, and when SEI growth on the anode surface of the battery cells 1 occurs. Figure 5 shows a schematic illustration of the theoretical change of state of the battery cells 1 during floating, when lithiation occurs on the cathode.

For illustration, Figs. 4 and 5 show zooms into the voltage curves of the anode and cathode of one of the battery cells 1, which are approximately linear. The x-coordinate represents the SOC of the entire or full battery cell 1, with the bottom lines depicting the voltage profiles of the anode and the top lines showing the voltage profiles of the cathode. The dashed curves refer to the states of the electrodes before aging, while the solid curves represent the states of the electrodes after aging.

To simplify, the float current measurement is herein exemplary divided into two phases: a voltage drop attributed to SEI formation, and the subsequent recharge current $I_{Recharge}$ necessary to maintain a constant cell voltage. These two processes, voltage drop due to aging and recharging, occur simultaneously. For illustration, a specific voltage drop caused by aging is considered first.

In the first step, the anode loses lithium to the SEI layer with a current $I_{SEI\_growth}$, leading to an increase in anode voltage shown with an arrow in Fig. 4. During this step, no current flows in the external circuit, and the lithium state of the cathode remains unchanged. By fixing the position of the anode curve, the cathode voltage curve must be shifted to the left to correspond to the actual lithium states (SOC) of the anode and cathode. The top arrow from the dashed top line to the solid top line shows the new state after aging, where the increase in anode potential and the remaining cathode potential together led to a voltage drop of the entire battery cell 1.

In the second step, the battery cell is recharged to maintain constant voltage with the current $I_{Recharge}$. Under potentiostatic conditions, recharging continues until the battery cell voltage again corresponds to the holding voltage level, as indicated by the arrows along the solid bottom and top lines. The left vertical line between the solid bottom and top lines represents the reduced voltage after aging, while the right vertical line between the solid bottom and top lines represents the holding voltage before aging. The vertical line in between the left and right vertical lines represents the same holding voltage after recharging.

The loss current $I_{SEI\_growth}$ in the first step is greater than the recharge current $I_{Recharge}$ in the second step. From the geometric relationship in Figure 4, the following equation can be derived for a Scaling Factor $SF_{Anode}$ for the anode:

$$SF_{Anode} = \frac{|k_{Anode}|}{|k_{full\,battery\,cell}|} = \frac{|k_{Anode}|}{|k_{Anode}| + |k_{Cathode}|} = \frac{1}{1 + \frac{|k_{Cathode}|}{|k_{Anode}|}} \quad \text{(Eq. 1).}$$

$K_{Full\,cell}$ is the voltage slope of the entire cell and $k_{Cathode}$ and $k_{Anode}$ denote the slopes of the voltage profiles of the cathode and anode of the battery cell 1.

Another effect that would also lead to a voltage drop is the lithiation of the cathode active material through electrolyte decomposition, called cathode lithiation, which leads to a voltage drop of the full battery cell 1 as the cathode voltage decreases. This less known effect of cathode lithiation rate can be described with different approaches. Compared to anodic SEI formation, this changes the "scaling factor" to "1-scaling factor," as the slope of the cathode voltage compared to the total battery cell voltage is now relevant. Therefore, the cathodic effect is particularly measurable in the float current at high SOCs. the following equation can be derived for a Scaling Factor $SF_{cathode}$ (also denoted $SF_C$ in Fig. 5) for the cathode:

$$SF_{Cathode} = \frac{|k_{Cathode}|}{|k_{full\,battery\,cell}|} = \frac{|k_{Cathode}|}{|k_{Anode}| + |k_{Cathode}|} \quad \text{(Eq. 2).}$$

Furthermore, the capacity loss rate $I_{C\_loss}$ would be reduced by the lithiation of the cathode, as lithium from the conductive salt of the electrolyte is actively stored in the cathode. This explains the differences between the capacity loss rate $I_{C\_loss}$ and the float currents $I_{float}$. Thus, the total recharge current is the sum of both effects and can be described as follows:

$$I_{float} = I_{Recharge} = SF_{Anode} \cdot I_{SEI\_growth} + SF_{Cathode} \cdot I_{Cathode\_Lithiation} \quad \text{(Eq. 3).}$$

Integrating the effect of cathode lithiation into the analysis, it is possible to better understand the interplay between different aging mechanisms and their influence on float currents $I_{float}$ and capacity loss rates $I_{C\_loss}$. This holistic view enables more accurate predictions of battery aging and improves the reliability of float current analysis as a diagnostic tool for assessing the health and lifespan of battery cells, in particular (but not limited to) lithium-ion batteries, in this example. Specifically, an LFP (Lithium iron phosphate) based battery cell A123, 1.1 Ah was used in this example.

The left graphic illustration in Fig. 6 shows the float current measurement of an exemplary battery cell 1 with Equation, Eq., 3. The middle graphic illustration in Fig. 6 shows the determined $k_{Anode}$ and $k_{Cathode}$ as part of $k_{full\,battery\,cell}$ based on the OCV measurement as herein explained. The right graphical illustration in Fig. 6 shows the determined capacity loss rate $I_{C\_loss}$ based on the check-up measurements as herein explained.

According to above Equation 3, there are two unknowns, $I_{SEI\_growth}$ and $I_{C\_loss}$. Equation 2 is then to be calculated using the check-up-based procedure as explained herein. Cathode lithiation leads to an apparent capacity gain, which, however, is neither visible in a Differential Voltage Analysis, DVA, of the OCV measurement nor represented in the capacity loss rate $I_{C\_loss}$. Thus, the capacity loss rate $I_{C\_loss}$ is to be described as:

$$I_{C\_loss} = I_{SEI\_growth} - I_{Cathode\_Lithiation} \quad \text{(Eq. 4).}$$

Now only the determination of the scaling factors SF is missing. The scaling factors, i.e., the ratio of the slope of the anode or cathode to the full battery cell 1, differs from battery cell 1 to battery cell 1. Since this depends on the cathode and anode voltage curve, it may be proceeded as follows.

First, as already described herein, the OCV of the full battery cell 1 may be measured, e.g. using the galvanostatic intermittent titration technique, GITT, during charging and discharging. The OCV curve is then obtained depending on the cell active materials by the average value of the charge and discharge curves, only the charge curve, or only the discharge curve. The background is hysteresis effects between charge and discharge curves. By deriving both voltage curves and calculating the DVA for charging and discharging, both DVAs may be compared regarding the x-position of the characteristic features. Averaging is purposeful if the features appear at the same x-position.

Second, the overall curve of the battery cell 1 may be divided into the cathode and anode curve using a well-founded estimation procedure, e.g. based on the battery cell type. This allows to calculate $k_{Anode}$ and $k_{Cathode}$ as graphically illustrated in the middle graph of Fig. 6.

Since all parameters are known, it is now possible to calculate $I_{SEI\_growth}$ and $I_{C\_loss}$. Figure 7 shows the plotted calendar aging characteristics for anode and cathode in terms of $I_{SEI\_growth}$ and $I_{C\_loss}$ for a check-up voltage measurement and a float current measurement. In Fig. 7, $I_{C\_loss,meas}$ and $I_{float,meas}$ denote the measured respective currents for the check-up voltage and the float current measurement, whereas $I_{C\_loss,sim}$ and $I_{float,sim}$ denote the simulated respective currents for the check-up voltage and the float current measurement as output or, in other words, result from the calendar aging model shown in Fig. 8

It can be seen that predominantly the cathode has the greatest effect on aging at higher SOCs or voltages. It can also be seen that $I_{SEI\_growth}$ and $I_{C\_loss}$ increase with increasing voltage. Another validation is that the float current $I_{float}$ at a higher sampling rate reproduces the shape of the scaling factors SF.

Fig. 8 shows the already mentioned calendar aging model, which may employ the above-described process with the respective Equations 1 to 4. With the measured float currents $I_{float}$, understanding of compensation processes in the battery cells 1 and aging processes can be understood with the help of suitable modeling. The combination of float current measurement and modeling makes it possible to achieve improved and, above all, faster lifetime predictions. The measurement methodology described herein can be applied in such a way that rapid parameterization of a lifetime model is possible within 8 to 16 weeks, thus reliably predicting at least 5 years of battery use.

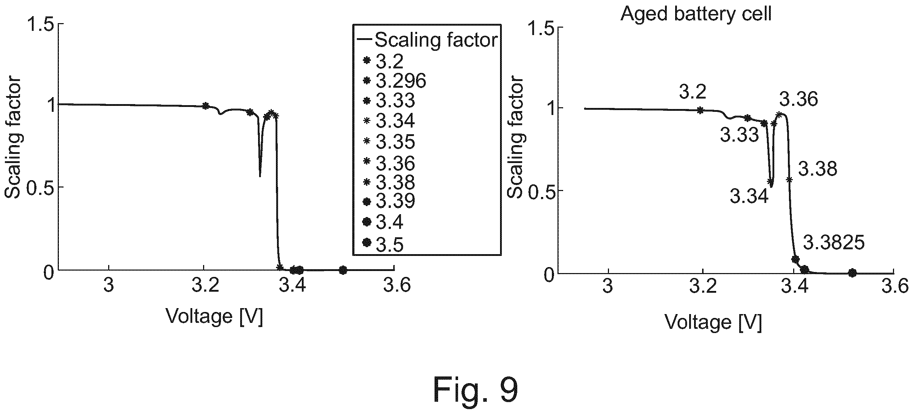

The calendar aging model may include the scaling factors SF that change over time. Specifically, Figure 9 shows graphical illustrations of scaling factors SF in dependency of cell voltage as determined by the calendar aging model of Fig. 8, including the change of the scaling factors SF over time for an aged battery cell.

Here, the same cell type with a higher sampling rate may be considered. For example, one can see how the float points shift to the left along the scaling factor SF over time. For all cells, the float currents $I_{float}$ and capacity losses $I_C$ were recorded and supplied as input. Here, $I_{SEI\_growth}$ and $I_{C\_loss}$ must always increase with voltage. The error bars in Fig. 9 serve to illustrate the change in the scaling factor SF.

As operating strategy of the method 100, the battery cells 1 may be kept at a substantially constant temperature of e.g. 30 °C as done in the tests described herein.

However, a particularly interesting application to be investigated is the determination of the stability of battery cells 1. For this purpose, the float current $I_{float}$ may be measured in the steady state with stepwise increase of temperature. The battery cell 1 is particularly long-term stable if the float current $I_{float}$ has not increased after a temperature profile at the reference temperature. If, on the other hand, it does not remain stable, the previous temperature profile influences aging and a path dependency exists, which is of particular importance for modeling and thus for lifetime prediction.

Also, a stepwise reduction of temperature is possible. Further, entropy measurement of the battery cells using ramps and validation with steps is possible. Further, other operating strategies are conceivable.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practicing the claimed invention, from a study of the drawings, the disclosure, and the claims.

As used herein, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Further, as used herein, the phrase "at least one" or similar, e.g., "one or more of', in reference to a list of one or more entities should be understood to mean at least one entity selected from any one or more of the entities in the list of entities, but not necessarily including at least one of each and every entity specifically listed within the list of entities and not excluding any combinations of entities in the list of entities. This definition also allows that such entities may optionally be present other than the entities specifically identified within the list of entities to which the phrase "at least one" or similar refers, whether related or unrelated to those entities specifically identified. Thus, as a non-limiting example, "at least one of A and B" (or, equivalently, "at least one of A or B" or, equivalently "at least one of A and/or B" or, equivalently "one or more of A and B", "one or more of A or B", or "one or more of A and/or B") may refer, in one example, to at least one, optionally including more than one, A, with no B present (and optionally including entities other than B); in another example, to at least one, optionally including more than one, B, with no A present (and optionally including entities other than A); in yet another example, to at least one, optionally including more than one, A, and at least one, optionally including more than one, B (and optionally including other entities). In other words, the phrases "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C," and "A, B, and/or C" may mean A alone, B alone, C alone, A and B together, A and C together, B and C together, A, B, and C together, and optionally any of the above in combination with at least one other entity.

As used herein, the phrase "being indicative of' may for example mean "reflecting" and/or "comprising". Accordingly, an entity, element and/or step referred to herein as "being indicative of [...]" can be synonymously or interchangeably used herein with one, two or all of said entity, element and/or step "comprising [...]" and said entity, element and/or step "reflecting [...]".

Further, as used herein, phrases such as "based on", "related" or "relating", "associated" and similar are not to be seen exclusively in terms of the entities, elements and/or steps to which they are referring, unless otherwise stated. Instead, these phrases are to be understood inclusively, unless otherwise stated, in that, for example, an entity, element or step referring by any of these phrases or similar, e.g., being "based on", an or another entity, element or step, does not exclude that the respective entity, element or step may be further or also "based on" any other entity, element or step than the one to which it refers.

Any designation of methods, steps and elements as first, second, etc. as provided herein is merely intended to make the methods, their steps and elements referenceable and distinguishable from one another. By no means does the designation of methods, steps and elements constitute a limitation of the scope of this disclosure. For example, when this disclosure describes a third step of a method, a first or second step of the method do not need to be present yet alone be performed before the third step unless they are explicitly referred to as being required per se or before the third step. Moreover, the presentation of methods or steps in a certain order is merely intended to facilitate one example of this disclosure and by no means constitutes a limitation of the scope of this disclosure. Generally, unless no explicitly required order is being mentioned, the methods and steps may be carried out in any feasible order. Specifically, the terms first, second, third or (a), (b), (c) and the like in the description and in the claims are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

In the context of the present invention any numerical value indicated is typically associated with an interval of accuracy that the person skilled in the art will understand to still ensure the technical effect of the feature in question. As used herein, the deviation from the indicated numerical value is in the range of $\pm$ 10%, and preferably of $\pm$ 5%. The aforementioned deviation from the indicated numerical interval of $\pm$ 10%, and preferably of $\pm$ 5% is also indicated by the terms "about" and "approximately" used herein with respect to a numerical value.

Any reference signs in the claims should not be construed as limiting the scope.

## Claims

1. A computer-implemented method (100) for determining an anode calendar aging characteristic and a cathode calendar aging characteristic of one or more battery cells (1) of the same battery cell type, the method (100) comprising:

   - obtaining check-up measurement data from check-up measurements of the one or more battery cells (1), the check-up measurement data being indicative of a capacity loss rate ($I_{C\_loss}$) of the one or more battery cells (1);
   - obtaining float current measurement data from a float current measurement of the one or more battery cells (1), the float current measurement data being indicative of a float current ($I_{float}$) of the one or more battery cells (1);
   - obtaining open circuit voltage, OCV, measurement data from an OCV measurement of one of the one or more battery cells (1), the OCV measurement data being indicative of an OCV of the one or more battery cells (1);
   - providing the check-up measurement data, the float current measurement data, and the OCV measurement data as input to a calendar aging model; and
   - determining, using the calendar aging model, the anode calendar aging characteristic and the cathode calendar aging characteristic, the anode calendar aging characteristic being indicative of calendar aging due to solid electrolyte interface, SEI, growth at an anode of the one or more battery cells (1), and the cathode calendar aging characteristic being indicative of calendar aging due to lithiation of a cathode of the one or more battery cells (1).

2. The method (100) of claim 1, wherein the check-up measurement data is from check-up measurements of several battery cells (1), in particular eight or more battery cells (1), of the same battery cell type, and the float current measurement data is from a float current measurement of the several battery cells (1), wherein each one of the several battery cells (1) has a different state of charge, SOC.

**3.** The method (100) of any one of the previous claims, wherein the anode calendar aging characteristic is indicative of an SEI growth current ($I_{SEI\_growth}$), and the cathode calendar aging characteristic is indicative of a cathode lithiation current ($I_{Cathode\_Lithiation}$).

**4.** The method (100) of claim 3, wherein the determining of the SEI growth current ($I_{SEI\_growth}$) and the cathode lithiation current ($I_{Cathode\_Lithiation}$) comprises:

  - determining, based on the OCV measurement data, an anode scaling factor ($SF_{Anode}$) for the SEI growth current ($I_{SEI\_growth}$) and a cathode scaling factor ($SF_{Cathode}$) for the cathode lithiation current ($I_{Cathode\_Lithiation}$), and
  - determining the SEI growth current ($I_{SEI\_growth}$) and the cathode lithiation current ($I_{Cathode\_Lithiation}$) based on the anode scaling factor ($SF_{Anode}$), the cathode scaling factor ($SF_{Cathode}$) and the float current ($I_{float}$).

**5.** The method (100) of claim 5, wherein the determining of the anode scaling factor ($SF_{Anode}$) and the cathode scaling factor ($SF_{Cathode}$) comprises:

  - determining a differential voltage capacity ($k_{full\ battery\ cell}$) of the one or more battery cells (1) using differential voltage analysis, DVA, of the OCV;
  - estimating an anode differential voltage capacity ($k_{Anode}$) of the anode and a cathode differential voltage capacity ($k_{Cathode}$) of the cathode as parts of the full differential voltage capacity ($k_{full\ battery\ cell}$); and
  - determining the anode scaling factor ($SF_{Anode}$) and the cathode scaling factor ($SF_{Cathode}$) based on the anode differential voltage capacity ($k_{Anode}$) and the cathode differential voltage capacity ($k_{Cathode}$).

**6.** The method (100) of claim 6, wherein the anode differential voltage capacity ($k_{Anode}$) and/or the cathode differential voltage capacity ($k_{Cathode}$) are estimated based on the battery cell type of the one or more battery cells (1).

**7.** The method (100) of claim 6 or 7, wherein the calendar aging model is based on the mathematical relationship of

$$SF_{Anode} = \frac{|k_{Anode}|}{k_{full\ battery\ cell}} \text{ (Eq. 1),}$$

$$SF_{Cathode} = \frac{|k_{Cathode}|}{|k_{full\ battery\ cell}|} \text{ (Eq. 2),}$$

$$I_{float} = SF_{Anode} \cdot I_{SEI\_growth} + SF_{Cathode} \cdot I_{Cathode\_Lithiation} \text{ (Eq. 3),}$$

and

$$I_{C\_loss} = I_{SEI\_growth} - I_{Cathode\_Lithiation} \text{ (Eq. 4)}$$

for determining the SEI growth current ($I_{SEI\_growth}$) and the cathode lithiation current ($I_{Cathode\_Lithiation}$).

**8.** The method (100) of any one of claims 5 to 7, wherein a change in the anode scaling factor ($SF_{Anode}$) and the cathode scaling factor ($SF_{Cathode}$) over time is determined.

**9.** The method (100) of any one of the previous claims, wherein the float current measurement data is indicative of the float current ($I_{float}$) of the one or more battery cells (1) during a steady state assumed after a settling time, after which anode overhang of the one or more battery cells (1) has substantially settled.

**10.** The method (100) of any one of the previous claims, wherein a first check-up measurement of the check-up measurements is carried out before the float current measurement and a second check-up measurement of the check-up measurements is carried out after the float current measurement.

**11.** The method (100) of any one of the previous claims, wherein at least the float current measurement data is from a float current measurement, in which the one or more battery cells (1) are kept at a substantially constant temperature, the temperature in particular being within the range of 20 to 40 °C.

12. The method (100) of any one of the previous claims, wherein at least the float current measurement data is from a float current measurement, in which a temperature of the one or more battery cells (1) is gradually increased or decreased.

13. A computer program product (12) comprising instructions which, when executed by a data processing system (10), instructs the data processing system (10) to carry out the method (100) according to any one of the previous claims.

14. A data processing system (10) configured to carry out the method (100) according to any one of claims 1 to 12.

15. A battery cell measurement system (1000), the battery cell measurement system (1000) comprising the data processing system (10) of claim 14, a constant voltage source (20), a current measurement device (30), one or more voltage measurement devices (40), and a temperature control device (50) for controlling the temperature of the one or more battery cells (1).

**Amended claims in accordance with Rule 137(2) EPC.**

1. A computer-implemented method (100) for determining an anode calendar aging characteristic and a cathode calendar aging characteristic of one or more battery cells (1) of the same battery cell type, the method (100) comprising:

 - obtaining check-up measurement data from check-up measurements of the one or more battery cells (1), the check-up measurement data being indicative of a capacity loss rate ($I_{C\_loss}$) of the one or more battery cells (1);
 - obtaining float current measurement data from a float current measurement of the one or more battery cells (1), the float current measurement data being indicative of a float current ($I_{float}$) of the one or more battery cells (1);
 - obtaining open circuit voltage, OCV, measurement data from an OCV measurement of one of the one or more battery cells (1), the OCV measurement data being indicative of an OCV of the one or more battery cells (1);
 - providing the check-up measurement data, the float current measurement data, and the OCV measurement data as input to a calendar aging model; and
 - determining, using the calendar aging model, the anode calendar aging characteristic and the cathode calendar aging characteristic, the anode calendar aging characteristic being indicative of calendar aging due to solid electrolyte interface, SEI, growth at an anode of the one or more battery cells (1), and the cathode calendar aging characteristic being indicative of calendar aging due to lithiation of a cathode of the one or more battery cells (1), wherein the cathode lithiation is lithiation of the cathode active material through electrolyte decomposition.

2. The method (100) of claim 1, wherein the check-up measurement data is from check-up measurements of several battery cells (1), in particular eight or more battery cells (1), of the same battery cell type, and the float current measurement data is from a float current measurement of the several battery cells (1), wherein each one of the several battery cells (1) has a different state of charge, SOC.

3. The method (100) of any one of the previous claims, wherein the anode calendar aging characteristic is indicative of an SEI growth current ($I_{SEI\_growth}$), and the cathode calendar aging characteristic is indicative of a cathode lithiation current ($I_{Cathode\_Lithiation}$).

4. The method (100) of claim 3, wherein the determining of the SEI growth current ($I_{SEI\_growth}$) and the cathode lithiation current ($I_{Cathode\_Lithiation}$) comprises:

 - determining, based on the OCV measurement data, an anode scaling factor ($SF_{Anode}$) for the SEI growth current ($I_{SEI\_growth}$) and a cathode scaling factor ($SF_{Cathode}$) for the cathode lithiation current ($I_{Cathode\_Lithiation}$); and
 - determining the SEI growth current ($I_{SEI\_growth}$) and the cathode lithiation current ($I_{Cathode\_Lithiation}$) based on the anode scaling factor ($SF_{Anode}$), the cathode scaling factor ($SF_{Cathode}$) and the float current ($I_{float}$).

5. The method (100) of claim 5, wherein the determining of the anode scaling factor ($SF_{Anode}$) and the cathode scaling factor ($SF_{Cathode}$) comprises:

 - determining a differential voltage capacity ($k_{full\ battery\ cell}$) of the one or more battery cells (1) using differential voltage analysis, DVA, of the OCV;
 - estimating an anode differential voltage capacity ($k_{Anode}$) of the anode and a cathode differential voltage capacity ($k_{Cathode}$) of the cathode as parts of the full differential voltage capacity ($k_{full\ battery\ cell}$); and
 - determining the anode scaling factor ($SF_{Anode}$) and the cathode scaling factor ($SF_{Cathode}$) based on the anode differential voltage capacity ($k_{Anode}$) and the cathode differential voltage capacity ($k_{Cathode}$).

6. The method (100) of claim 6, wherein the anode differential voltage capacity ($k_{Anode}$) and/or the cathode differential voltage capacity ($k_{Cathode}$) are estimated based on the battery cell type of the one or more battery cells (1).

7. The method (100) of claim 6 or 7, wherein the calendar aging model is based on the mathematical relationship of

$$SF_{Anode} = \frac{|k_{Anode}|}{k_{full\ battery\ cell}} \text{ (Eq. 1),}$$

$$SF_{Cathode} = \frac{|k_{Cathode}|}{|k_{full\ battery\ cell}|} \text{ (Eq. 2),}$$

$$I_{float} = SF_{Anode} \cdot I_{SEI\_growth} + SF_{Cathode} \cdot I_{Cathode\_Lithiation} \text{ (Eq. 3), and}$$

$$I_{C\_loss} = I_{SEI\_growth} - I_{Cathode\_Lithiation} \text{ (Eq. 4)}$$

for determining the SEI growth current ($I_{SEI\_growth}$) and the cathode lithiation current ($I_{Cathode\_Lithiation}$).

8. The method (100) of any one of claims 5 to 7, wherein a change in the anode scaling factor ($SF_{Anode}$) and the cathode scaling factor ($SF_{Cathode}$) over time is determined.

9. The method (100) of any one of the previous claims, wherein the float current measurement data is indicative of the float current ($I_{float}$) of the one or more battery cells (1) during a steady state assumed after a settling time, after which anode overhang of the one or more battery cells (1) has substantially settled.

10. The method (100) of any one of the previous claims, wherein a first check-up measurement of the check-up measurements is carried out before the float current measurement and a second check-up measurement of the check-up measurements is carried out after the float current measurement.

11. The method (100) of any one of the previous claims, wherein at least the float current measurement data is from a float current measurement, in which the one or more battery cells (1) are kept at a substantially constant temperature, the temperature in particular being within the range of 20 to 40 °C.

12. The method (100) of any one of the previous claims, wherein at least the float current measurement data is from a float current measurement, in which a temperature of the one or more battery cells (1) is gradually increased or decreased.

13. A computer program product (12) comprising instructions which, when executed by a data processing system (10), instructs the data processing system (10) to carry out the method (100) according to any one of the previous claims.

14. A data processing system (10) configured to carry out the method (100) according to any one of claims 1 to 12.

15. A battery cell measurement system (1000), the battery cell measurement system (1000) comprising the data processing system (10) of claim 14, a constant voltage source (20), a current measurement device (30), one or more voltage measurement devices (40), and a temperature control device (50) for controlling the temperature of the one or more battery cells (1).

Fig. 1

Fig. 2

Fig. 3

EP 4 782 855 A1

Fig. 5

Fig. 4

$$I_{float} = SF_{anode} \cdot I_{SEI\ growth} + SF_{cathode} \cdot I_{CL} + \underbrace{\cancel{I_{Shuttle}}}_{\approx 0} \quad k_{anode}\ \&\ k_{cathode}$$

$$I_{c\_loss} = I_{SEI\ growth} - I_{CL}$$

## Fig. 6

EP 4 782 855 A1

Fig. 7

$$SF_{cathode} = (1 - SF_{anode}) = \cfrac{1}{1 + \cfrac{k_{anode}}{k_{cathode}}}$$

$$SF_{anode} = \cfrac{1}{1 + \cfrac{k_{anode}}{k_{cathode}}}$$

Capacity loss rate

Floating current

Slope of Capacity test

Lithiation of cathode

SEI growth

Lithiation of cathode $\cdot SF_{cathode}$

SEI growth $\cdot SF_{anode}$

Constant Steady-State Float Current

$\cdot SF_{cathode}$

$\cdot SF_{anode}$

Voltage [V]

3  3.2  3.4  3.6

0  0.4  0.8

1  0.6  0.4  0

$$I_{c\_loss} = I_{SEI\ growth} \cdot I_{CL}$$

$$I_{float} = SF_{anode} \cdot I_{SEI\ growth} + SF_{cathode} \cdot I_{CL}$$

Fig. 8

Fig. 9

**EP 4 782 855 A1**

EUROPäisches
Patentamt

European
Patent Office

Office européen
des brevets

# EUROPEAN SEARCH REPORT

**Application Number**

EP 25 15 3345

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DATABASE INSPEC [Online] THE INSTITUTION OF ELECTRICAL ENGINEERS, STEVENAGE, GB; 22 July 2021 (2021-07-22), THEILER M ET AL: "Float Current Analysis for Fast Calendar Aging Assessment of 18650 Li(NiCoAl)O2/Graphite Cells", XP002813420, Database accession no. 21093424 * the whole document * & BATTERIES MDPI SWITZERLAND, vol. 7, no. 2, 22 July 2021 (2021-07-22), - 22 July 2021 (2021-07-22), pages 22-39, ISSN: 2313-0105, DOI: 10.3390/BATTERIES7020022 * the whole document * ----- | 1-15 | INV. G01R31/396 G01R31/367 G01R31/392 |
| X | US 2024/069109 A1 (SINGER JAN [DE] ET AL) 29 February 2024 (2024-02-29) * paragraph [0006] - paragraph [0010] * * paragraph [0023] - paragraph [0082] * * abstract; claims 1-18; figures 1-7 * ----- | 1-15 | |
| X | LEWERENZ MEINERT ET AL: "New method evaluating currents keeping the voltage constant for fast and highly resolved measurement of Arrhenius relation and capacity fade", JOURNAL OF POWER SOURCES, ELSEVIER, AMSTERDAM, NL, vol. 353, 7 April 2017 (2017-04-07), pages 144-151, XP029983139, ISSN: 0378-7753, DOI: 10.1016/J.JPOWSOUR.2017.03.136 * the whole document * ----- -/-- | 1-15 | TECHNICAL FIELDS SEARCHED (IPC) G01R |

The present search report has been drawn up for all claims

| Place of search | Date of completion of the search | Examiner |
|---|---|---|
| Munich | 7 July 2025 | Nadal, Rafael |

page 1 of 2

Europäisches
Patentamt

European
Patent Office

Office européen
des brevets

## EUROPEAN SEARCH REPORT

**Application Number**

EP 25 15 3345

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | AZZAM MOHAMED ET AL:  "Accelerating float current measurement with temperature ramps revealing entropy insights", JOURNAL OF ENERGY STORAGE, ELSEVIER BV, NL, vol. 102, 16 October 2024 (2024-10-16), XP087648207, ISSN: 2352-152X, DOI: 10.1016/J.EST.2024.114142 [retrieved on 2024-10-16] * the whole document * ----- | 1-15 | |

TECHNICAL FIELDS
SEARCHED       (IPC)

The present search report has been drawn up for all claims

| Place of search | Date of completion of the search | Examiner |
|---|---|---|
| Munich | 7 July 2025 | Nadal, Rafael |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

&.............................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 25 15 3345

This annex lists the patent family members relating to the patent documents cited in the above-mentioned European search report.
The members are as contained in the European Patent Office EDP file on
The European Patent Office is in no way liable for these particulars which are merely given for the purpose of information.

07-07-2025

| Patent document cited in search report | Publication date | Patent family member(s) | Publication date |
|---|---|---|---|
| US 2024069109 A1 | 29-02-2024 | CN 117630674 A | 01-03-2024 |
| | | EP 4332598 A1 | 06-03-2024 |
| | | US 2024069109 A1 | 29-02-2024 |

EPO FORM P0459

For more details about this annex : see Official Journal of the European Patent Office, No. 12/82